# EUROPEAN PATENT APPLICATION

(11) **EP 0 825 650 A2**
(43) Date of publication of application: **25.02.1998**
(21) Application number: 97306353.0
(22) Date of filing: 20.08.1997
(51) Int. Cl.: H01L 27/108, H01L 21/8242

(54) **DRAM cell with stacked capacitor**

(30) Priority: 21.08.1996 US 24250 P
(71) Applicant: TEXAS INSTRUMENTS INC., Dallas, Texas 75243 (US)
(72) Inventor: Moroi, Masayuki, No. 226 Richardson, Texas 75080 (US); Hirose, Kiyomi, Tsukuba City, Ibaraki 305 (JP); Boku, Katsushi, Ibaraki 300-11 (JP)
(74) Representative: Williams, Janice

(57) **Abstract**

A single transistor stacked DRAM memory cell 8 includes a transfer gate 18 formed over a semiconductor region 10 and insulated therefrom. A bit line contact region 16 is disposed in the semiconductor region adjacent a first edge of the transfer gate 18. A storage node contact region 14 is disposed in the semiconductor region 10 adjacent a second edge of the transfer gate 18. The storage node contact region 14 is spaced from the bit line contact region 16 by a channel region. A cylindrical spacer region 28 is disposed over the semiconductor region 10. This spacer region 28 surrounds the storage node contact region 14 so as to expose this contact region 14. A conductive storage node 22 surrounds inner, outer and upper portions of the spacer region 28 and is electrically coupled to the storage node contact region 14. A conductive plate 26 is capacitively coupled to the storage node 22.

## Description

### FIELD OF THE INVENTION

This invention relates generally to the fabrication of semiconductor devices and more particularly to memory cells, memory devices, in particular DRAM devices, and fabrication methods relating thereto.

### BACKGROUND OF THE INVENTION

Dynamic random access memory (DRAM) devices are used in a great number of applications. Each DRAM cell includes a pass transistor and a storage capacitor connected in series. The gate electrode of the memory cell's pass transistor is connected to a word line which extends in the row direction so that the transistor is controlled through this word line. The other semiconductor region of the pass transistor is connected to a bit line (data Line) which extends in the column direction.

Attempts are continuously being made to increase integration density for the purpose of increasing the memory capacity. Therefore, the tendency is for memory cell sizes to shrink. When the memory cell sizes are reduced, the size (area) of the capacitor elements is also reduced. This reduction in size results in a decrease in the capacity of the memory cell to store the charge which constitutes information. As the charge storing capacity decreases, the effect of minority carriers generated due to alpha- particles increases, so that so-called soft errors are likely to occur. This occurrence of soft errors is particularly a problem in DRAMs having high integration density, such as 1 Mbit or more.

In view of this problem of soft errors generated due to alpha-particles, stacked capacitor elements have been adopted as information storage capacitor elements of the memory cells of DRAMs. A stacked capacitor includes a first electrode layer, a dielectric film and a second electrode layer, which are successively stacked on a semiconductor substrate. The first electrode layer is formed so that part of the first electrode layer of the stacked capacitor is connected to one semiconductor region of the corresponding pass transistor. Another part of the first electrode extends above the gate electrode of the pass transistor.

Examples of a stacked capacitor DRAM devices are shown in U.S. Patent No. 5,153,685 and Japanese Kokai 183,952/1986. Another stacked capacitor cell is taught by Eimori et al., "ULSI DRAM/SIMOX with Stacked Capacitor Cells for Low-Voltage Operation," 1993 IEDM, pp. 45-48. This paper discloses an SOI-DRAM device. Cylindrical capacitor structures are discussed by both Watanabe et al., "A New Cylindrical Capacitor Using Hemispherical Grained Si (HSG-Si) for 256Mb DRAMS," 1992 IEDM, pp. 259-262 and Fazan et al., "A High-C Capacitor (20.4 fF/µm²) with Ultrathin CVD-Ta₂O₅ Films Deposited on Rugged Poly-Si for High Density DRAMs," 1992 IEDM, pp. 263-266.

### SUMMARY OF THE INVENTION

A memory cell of one aspect of the present invention includes a transfer gate formed over a semiconductor region and insulated therefrom. A bit line contact region is disposed in the semiconductor region adjacent a first edge of the transfer gate. A storage node contact region is disposed in the semiconductor region adjacent a second edge of the transfer gate. A cylindrical spacer region is disposed over the semiconductor region. This spacer region surrounds the storage node contact region so as to expose this contact region. A conductive storage node surrounds inner, outer and upper portions of the spacer region and is electrically coupled to the storage node contact region. A conductive plate is capacitively coupled to the storage node.

Respective further aspects of the invention are set forth in claims 1, 12, 20 and 28.

Embodiments of the present invention provide a single transistor stacked DRAM cell which has a number of advantages over prior art devices.

A method of forming a capacitor for a semiconductor device as disclosed herein can be used in conjunction with the formation of a DRAM cell. In one embodiment of the invention, a conductive layer is formed over a surface. This conductive layer is then patterned and etched to form an opening which exposes a portion of the surface. A sidewall spacer is formed along inner walls of the opening. In one embodiment, the sidewall spacer can be formed by conformally depositing a layer of insulating material and anisotropically etching this insulating layer to form the sidewall spacer along the inner walls of the opening. A second conductive layer is then formed over the first conductive layer, the sidewall insulator and the exposed portion of the surface. The first and second conductive layers can then be patterned and etched to form a storage node conductor. The storage node conductor surrounds the sidewall insulator. A dielectric layer is then formed over the storage node conductor. Finally, a third conductive layer is formed over the dielectric layer.

Embodiments of the invention have a number of advantages over prior art memory devices. For example, the memory cell is compact. The storage node of the capacitor is designed to contact the pass transistor in a region which can be only 0.15 microns or even less. Small features facilitate the fabrication of a great many memory cells on a single chip. For example, over 64 million memory cells of the present invention can be fabricated on a single chip.

Methods embodying the present invention are also advantageous because the number of process steps has been reduced as compared with other process flows. When fewer process steps are needed, the cost of manufacture and opportunity to create defects are both reduced.

### BRIEF DESCRIPTION OF THE DRAWINGS

The above features of the present invention will be more clearly understood from consideration of the following descriptions of exemplary embodiments in connection with accompanying drawings in which:
Figure 1a is a cross-sectional view of a first embodiment memory cell and Figure 1b is a schematic diagram of the cell of Figure 1a;
Figure 2 is a cross-sectional view of two memory cells in an array of cells according to a first embodiment of the present invention;
Figure 3a illustrates an array of memory cells;
Figure 3b illustrates a simplified block diagram of a memory device;
Figures 4-17 each illustrate three views of a device after selected steps of a fabrication process according to an embodiment of the present invention;
Figure 18 is a cross-sectional view of an alternate embodiment memory cell; and
Figures 19a and 19b illustrate a cross-sectional view of an alternative embodiment memory cell.

Corresponding numerals and symbols in the different figures refer to corresponding parts unless otherwise indicated.

### DETAILED DESCRIPTION OF ILLUSTRATIVE EMBODIMENTS

The making and use of the various embodiments are discussed below in detail. However, it should be appreciated that the present invention provides many applicable inventive concepts which can be embodied in a wide variety of specific contexts. The specific embodiments discussed are merely illustrative of specific ways to make and use the invention, and do not limit the scope of the invention.

The following specification will describe a novel dynamic random access memory (DRAM) cell and cell array. First, a single cell will be described followed by a description of an array. A preferred process for making the cell will then be discussed along with variations.

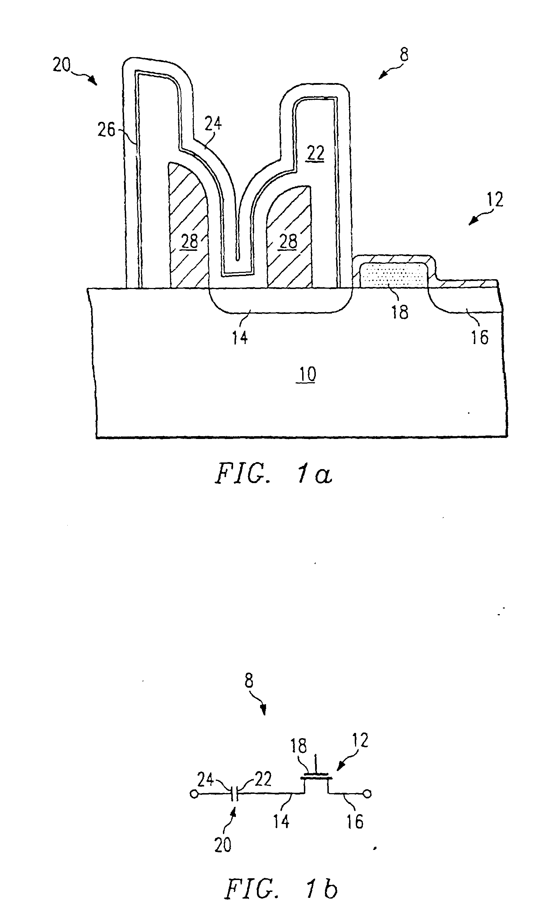

Figure 1a illustrates a cross-sectional view of a first embodiment memory cell of the present invention. For reference, Figure 1b shows an electrical schematic of the memory cell. Of course, the schematic diagram of a single cell DRAM has been known for many years.

The present embodiment is fabricated in a p-type silicon substrate 10. But the device can be formed in any semiconductor layer 10. For example, the semiconductor layer 10 can comprise a substrate, an epitaxially grown layer, a well (or tub or tank) region formed within another layer, or a semiconductor layer formed over another layer such as a semiconductor-on-insulator (SOI) where the insulator comprises an oxide, nitride or sapphire layer. While the semiconductor layer 10 is described as a p-type layer, an n-type layer would also be suitable so long as the other dopants are varied accordingly.

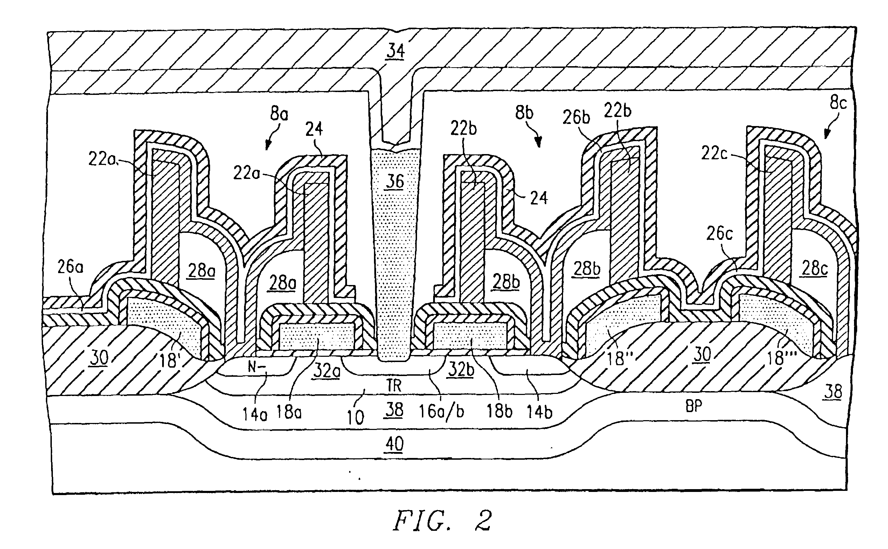

The memory 8 includes a pass transistor 12 and a capacitor 20. The *pass* transistor 12 includes first and second semiconductor regions 14 and 16 as well as a transfer gate 18. In this discussion, the semiconductor region 14 will often be referred to as storage node contact region 14 since the transistor 12 contacts the storage node plate 22 of capacitor 20 via this region 14. Semiconductor region 16 will often be referred to as bit line contact region 16 because the bit line or bit line contact (neither shown in Figure la; see Figure 2) are electrically coupled to the transistor 12 via this region. The semiconductor regions 14 and 16 may comprise n-doped regions or may be left at the same dopant concentration as the substrate 10.

Capacitor 20 includes a first plate 22 (referred to herein as storage node 22) and a second plate 24 (referred to herein as capacitor plate 24 or simply plate 24). The plates 22 and 24 may be formed of any conducting material. In the preferred embodiment, the plates 22 and 24 are both formed from doped polycrystalline silicon. Alternatively, a metal (e.g., aluminum, gold, copper, silver, platinum), conductive metal compound (e.g., nitride such as titanium nitride, oxide such as zinc oxide or tin oxide) or silicide material (e.g., titanium silicide, tantalum silicide) can be used. The first plate 22 may be formed from the same or a different material than second plate 24.

In the illustration of Figure 1a, the storage node 22 is smooth. This feature, however, is not required. In other embodiments, the storage node 22 can comprise rugged polysilicon or rugged hemispherical grain (HSG) polysilicon. By varying the texture of storage node 22, the capacitance of capacitor 20 can be increased.

The capacitor plates 22 and 24 are separated by dielectric layer 26. Dielectric layer 26 may comprise an oxide or a nitride layer or combinations thereof. In another embodiment, tantalum pentoxide (Ta₂0₅) can be used with polysilicon or TiN /polysilicon plate electrodes 22 and/or 24. Alternatively, dielectric layer 26 may comprise a high-dielectric-constant (high-K) material such as barium strontium titanate (BST). The layer 26 may also comprise other perovskite, pyroelectric, ferroelectric, or high-dielectric-constant oxides such as (Ba,Sr,Ca,PbXTi,Zr)O₃, (Pb,La)(Zr,Ti)O₃, bismuth titanate, potassium tantalate, lead scandium tantalate, lead niobate, potassium niobate, lead zinc niobate, lead magnesium niobate, tantalum pentoxide, yttrium oxide, or strontium bismuth tantalate. Donor, acceptor, or donor and acceptor doped oxides of the above materials may also be used. The present invention further encompasses combinations of the above materials or layers of the above materials.

As is known, some capacitor dielectrics 26 are more suitably used with certain capacitor electrode materials 22/24. For example, a BST dielectric 26 may be suitable for use with a platinum or other oxide stable material (e.g., palladium, iridium, rbenium, rhodium, gold or silver). In another example, an SrTi0₃ dielectric layer 26 can be used with a Ru0₂ storage node 22 and a Al/TiN cell plate (see Lesaicherre et al., 1994 IEDM, pp. 831-834). These examples demonstrate that the present invention is intended to encompass a great number of material combinations.

The capacitor 20 surrounds a spacer region 28. The spacer region 28 is an cylindrical region which surrounds storage node contact region 14. Storage node contact region 14 is exposed through the opening within spacer 28. Spacer 28 has been defined as a cylindrical shaped region. For the purposes of this patent, this definition should be interpreted to mean any shape which includes an opening. From a top view, the spacer 28 may be circular, oval, rectangular, polygonal or another shape. The only limitation required is that the spacer 28 extend outward from the substrate 10 and include an opening to expose the storage node contact region 14.

As illustrated in Figure la, the capacitively coupled layers 22 and 24 extend upward from a portion of the semiconductor layer adjacent an inner portion of the spacer 28, over the spacer 28 and downward toward a portion of the semiconductor layer adjacent an outer portion of the spacer 28. In the preferred embodiment, storage node 22 surrounds inner, outer and upper portions of spacer region 28. By surrounding the spacer, the surface area of capacitor 20 is increased as compared with capacitors which only contact one side and the top of the spacer.

Figure 2 illustrates two memory cells 8a and 8b (and a portion of a third memory cell 8c). This figure shows how two memory cells 8a and 8b can be formed in a single moat or active region 10. Both of the memory cells 8a and 8b are similar to memory cell 8 described with respect to Figure 1. As described before, each memory cell 8a (8b) includes a transfer gate 18a (18b), a channel region 32a (32b) beneath the transfer gate 18a (18b), a bit line contact region 16a/b, a storage node contact region 14a (14b), a cylindrical spacer region surrounding storage node contact region 14a (14b), a storage node 22a (b) surrounding inner, outer and upper portions of the spacer region 28a (28b) and contacting the storage node contact region 14a (14b), and a plate 24a (24b) capacitively coupled to the storage node 22a (22b).

The memory cells 8a and 8b are formed in active region 10. The active region 10 comprises a doped region. For example, in the preferred embodiment active region 10 can be doped with BF₂+ to adjust the threshold value of pass transistor 12. The active region 10 includes a lightly doped region 38 (e.g., p-doped with boron) which has a buried p-layer 40 formed thereunder. The buried p-layer is disposed in a p-tank.

Active region 10 is separated from other active regions by field isolation regions 30. A purpose of the field isolation regions is to electrically isolate adjacent active areas 10 from one another. In the preferred embodiment, the field isolation regions 30 comprise thermally grown oxide regions. Other isolation techniques can alternatively be used. For example, adjacent regions can be electrically isolated using trench isolation, e.g., trenches which are filled with an insulation material such as an oxide, nitride or undoped semiconductor.

As shown in Figure 2, bit line 34 is electrically coupled to the pass transistor 12 at bit line contact region 16. In this example, both memory cells 8a and 8b share a single bit line contact region 16a/b. In the preferred embodiment, the bit line 34 comprises a metal material such as titanium or tungsten. Other metals such as aluminum, copper, gold, silver, molybdenum, platinum or cobalt can be used. Alternatively, a metal silicide or polysilicon layer can be used. These materials can be used in combination or in layers.

The bit line 34 is coupled to the bit line contact region 16a/b via bit line contact 36. In the preferred embodiment, bit line contact 36 comprises a polysilicon plug. Alternatively, a metal plug or other interconnect can be used.

Word lines 18' (18" and 18"') are also illustrated in Figure 2. These word lines constitute the transfer gates 18 of memory cells coupled to other bit lines. Accordingly, they will be formed of the same material (or combinations of materials) as previously described with respect to the transfer gate 18.

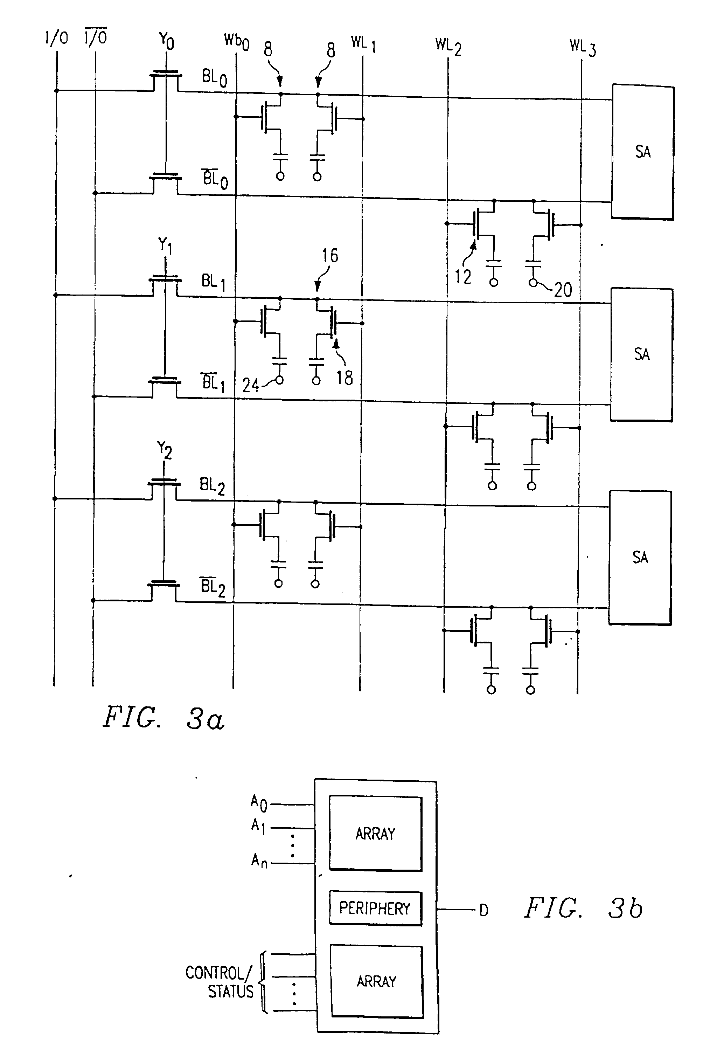

As illustrated in Figure 3a, a plurality of memory cells 8 can be formed in an array of rows and columns. Figure 3a illustrates only six bit lines BL and four word lines WL in what in actuality would likely be a much larger array. The pass transistor 12 of each memory cell has a gate 18 coupled to a word line WL and a source/drain region 16 coupled to a bit line BL. Comparing the array of Figure 3 with the cross-sectional view of Figure 2, if bit line 34 is BL0 (or BL1 or BL2) then transfer gate 18a is equivalent to WL0, transfer gate 18b is equivalent to WL1, word line 18" is equivalent to WL2, and word line 18"' is equivalent to WL3. (Word line 18' is not shown schematically in this small portion of the array.)

In an actual memory array, the memory cells, bit lines and word lines are formed over one another in order to save real estate. Accordingly, spacer 28a is formed over a portion of transfer gate 18a and also over a portion of word line 18'. In this manner, storage node 22a overlies a portion of transfer gate 18a adjacent a first edge of the transfer gate and a portion of word line 18' adjacent a first edge of the word line 18'.

Figure 3a also illustrates some of the peripheral circuitry which would be included in a memory array. For example, each pair of bit lines BL and BL(bar) is coupled to a sense amplifier SA. The bit lines BL and BL(bar) are also coupled to input/outline lines I/O and I/O(bar) through select transistors Y₀-Y₂. Other peripheral circuitry such as the row decoders, column decoders, address buffers, I/O buffers and so on are not illustrated here. As previously noted, the memory cell and fabrication method of the present invention are independent of the memory architecture.

As an example, the memory array can be designed as an asynchronous memory or as a synchronous memory. A synchronous memory can bc timed with an internal clock or an external clock. The device can have a single external data terminal or multiple external data terminals (i.e., wide word). The array can include a total of 4 megabits, 16 megabits, 64 megabits, 256 megabits or one gigabit.

A simplified block diagram of a memory device is shown in Figure 3b. The internal device circuitry includes an array and peripheral circuitry. The array may be divided into a number of blocks depending upon the device architecture. Sense amplifiers may be interleaved within the array blocks.

Several external terminals are illustrated in Figure 3b. Address terminals A₀, A₁, ..., Aₙ are provided for receiving row and column addresses. These terminals may be multiplexed (i.e., a first address is applied at a first time and a second address applied at a second time). A single data terminal D is also illustrated. This terminal may comprise an input, an output or an input/output. Other data terminals may also be included. For example, a wide word device will have multiple data terminals. In general, these terminals are provided for receiving input signals from circuitry (not shown) external to the array and for providing output signals to circuitry (not shown) external of the array.

Figure 3b also illustrates a number of control/status signals. These signals are used to operate the memory device. For example, an asynchronous memory device may be operated by applying chip select, row address strobe and column address strobe signals. Other signals may indicate whether a read or write operation is being performed. In a synchronous device, one of the control signals may be a clock signal. Status signals may provide information about the device to the external system. For example, the device may include a signal indicating whether a refresh operation is taking place or which portion of the array is being accessed.

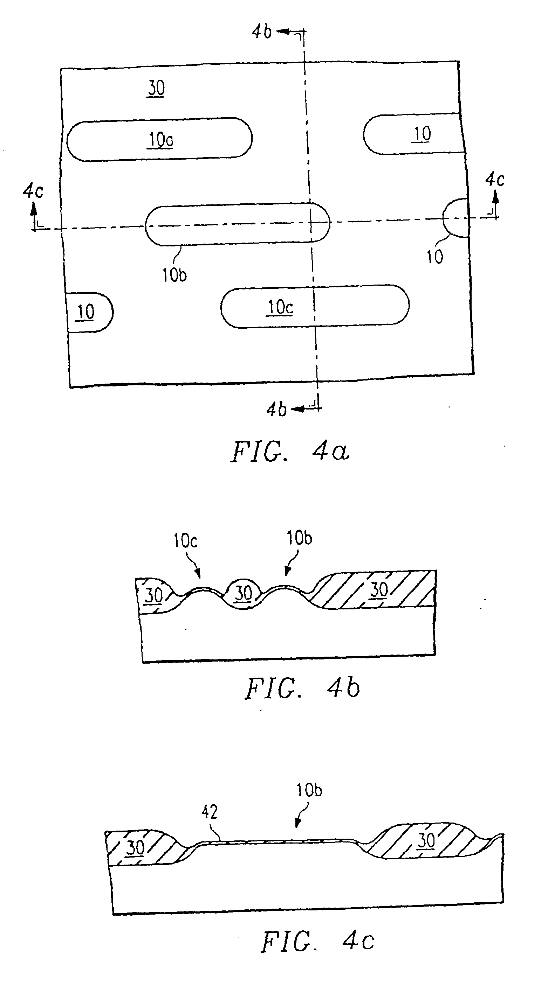

A preferred embodiment method of manufacturing the DRAM device embodying the present invention is described with respect to Figures 4-17. Each of these figures includes three views - (a) shows a top plan view and (b) and (c) show cross-sectional views of the device. In this discussion, Figure 4 will refer collectively to figure 4a, Figure 4b and Figure 4c and so on for the other figures.

The description of the process flow is supplemented by Table 1 which provides a more detailed list of process steps. The first column in Table 1 simply numbers the steps while the second column lists the figure in which the step is first performed. The third column provides the specific process steps. The fourth column provides an exemplary range of process parameters along with a specific preferred value. It is understood that the process parameters listed in the fourth column are merely exemplary and could be varied without leaving the scope of the invention.

The plan view in Figure 4a illustrates three full active areas, each labeled with reference numeral 10. Portions of three other active areas 10 are also shown. Each of these active areas will include two memory cells as illustrated in Figure 2. The active regions are disposed along a diagonal across the device as was schematically illustrated in Figures 3a and 3b.

While not illustrated in Figure 4, several processing steps will also be performed to begin fabrication of peripheral circuitry on the semiconductor layer 10 (or more generally, on the same device even if the same layer 10 is not used) . Peripheral circuitry for DRAM devices are known and will include such elements as sense amplifiers, row and column decode circuitry, input and output circuits, test circuitry and other elements. The specific cell described herein is independent of the overall memory architecture. In other words, this cell can be used with a great number of architectures both now known and at this time not yet invented.

As illustrated in Figures 4b and 4c, a gate dielectric 42 has been formed over the active region 10. In the preferred embodiment, gate dielectric 42 comprises a layer of about 120Å of silicon dioxide. In other embodiments, other oxides may be used. Alternatively, a nitride (e.g., Si₃N₄) or combination of oxide and nitride (e.g., oxide-nitride, nitride-oxide, oxide-nitride-oxide, oxynitride) layer can be used.

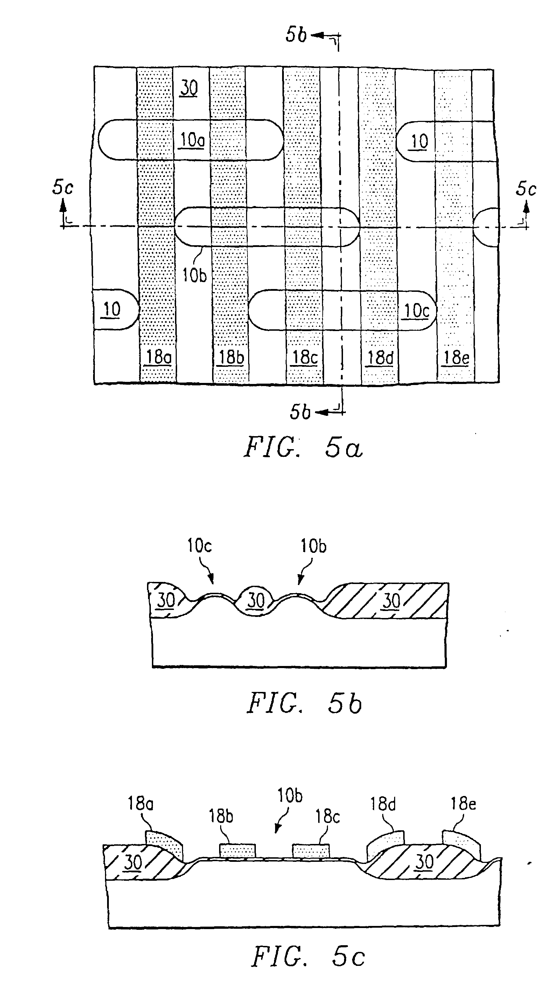

Referring next to Figure 5, a first conductive layer 18 is formed over the device. Conductive layer 18 is then patterned and etched to form a plurality of parallel word lines 18a-18e. Each of these word lines 18 will be used as the transfer gate of a number of memory cells. In the preferred embodiment, the word lines 18 are formed from heavily doped polysilicon. Other conductors such as metals (e.g., copper, aluminum, gold, refractory metals) or silicides (e.g., titanium silicide, tungsten silicide) can be used.

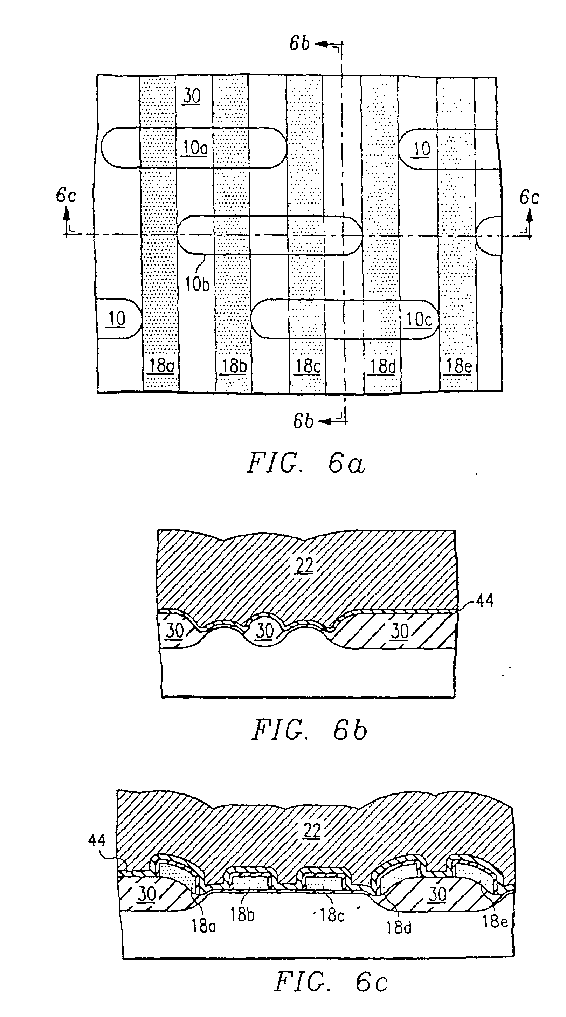

A dielectric layer 44 is formed over each of the word lines 18. This step is illustrated in Figure 6. In the preferred embodiment this dielectric layer 44 comprises an oxide layer but other dielectrics such as nitride or combinations of oxides and nitrides can be used.

At this point, the region between word lines 18 can be doped. This doping step will provide the lightly doped drain (LDD) structure for the pass transistor. As an example, an n-dopant implant, such as a phosphorus implant, can be performed at an energy level of about 40 KeV and a concentration of about 2 x 10¹³ cm⁻².

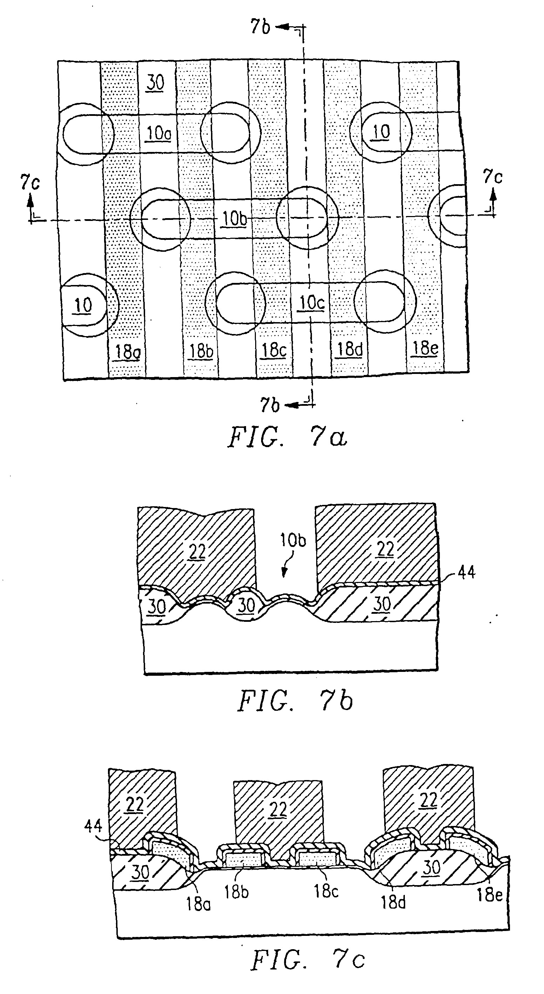

The storage node conductor 22 is then formed. In the preferred embodiment, about 6900Å of doped polysilicon is deposited using a chemical vapor deposition. Other conductors can alternatively be used. As illustrated in Figure 7, the storage node conductor layer 22 is patterned and etched so that each storage node conductor 22 will partially overlap two adjacent word lines 18. Standard patterning and etching techniques can be used. The storage node 22 can be formed as a smooth structure or as a rugged structure. For example, the storage node 22 can be a rugged hemispherical grain (HSG) structure.

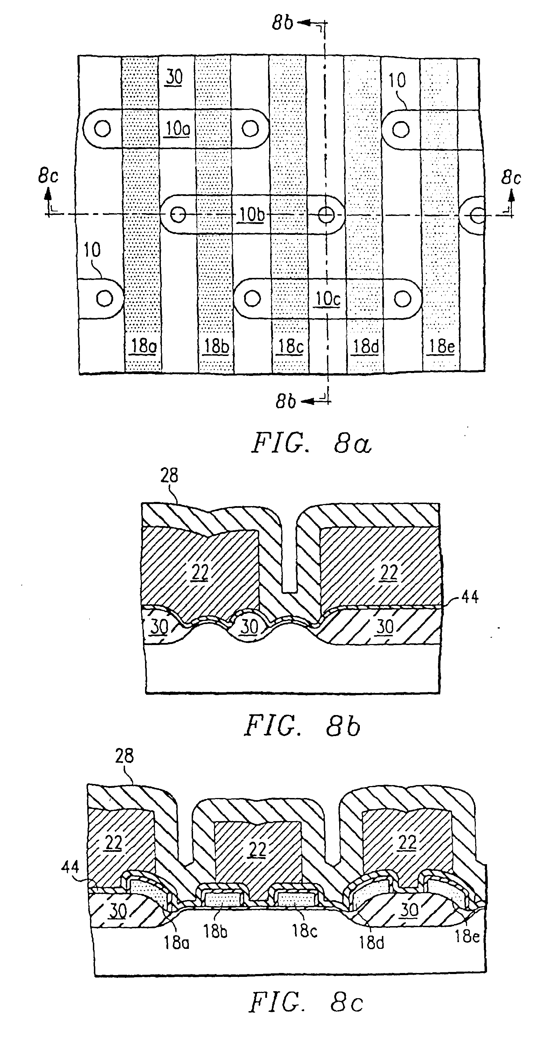

A capacitor spacer layer 28 is then formed over the device. This step is illustrated in Figure 8. The capacitor spacer layer 28 preferably comprises a 2300Å layer of silicon dioxide although other insulators such as nitride or combinations of oxide and nitride can also be used.

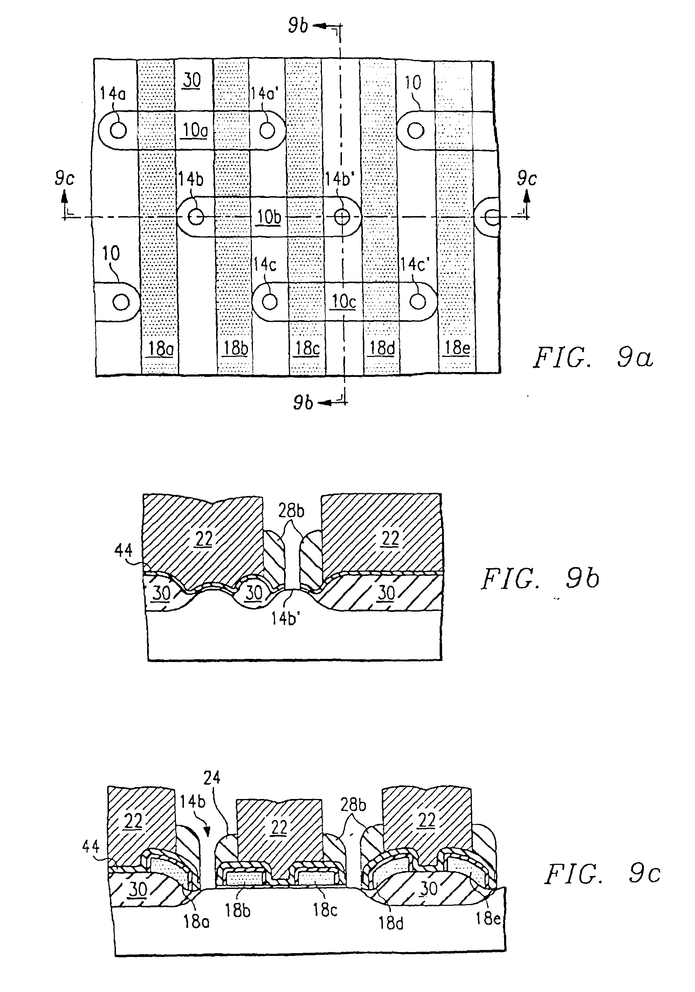

Continuing with Figure 9, spacer regions 28 can then be formed by anisotropically etching the insulating layer 28. This etching step will form sidewalls along a portion of the storage node conductor 22. The etching step should continue so that a portion of the moat region 10 is exposed. The storage node contact region 14 between the cell's capacitor and pass transistor will be formed in this exposed portion of the moat region 10.

As illustrated in Figure 9a, the storage node contact region 14 can be circular. However, this shape is not required. In other embodiments, the storage node contact region will be oval or rectangular (likely with rounded edges). As illustrated by Figures 9b and 9c, the sidewall spacer 28 will surround the storage node contact region 14.

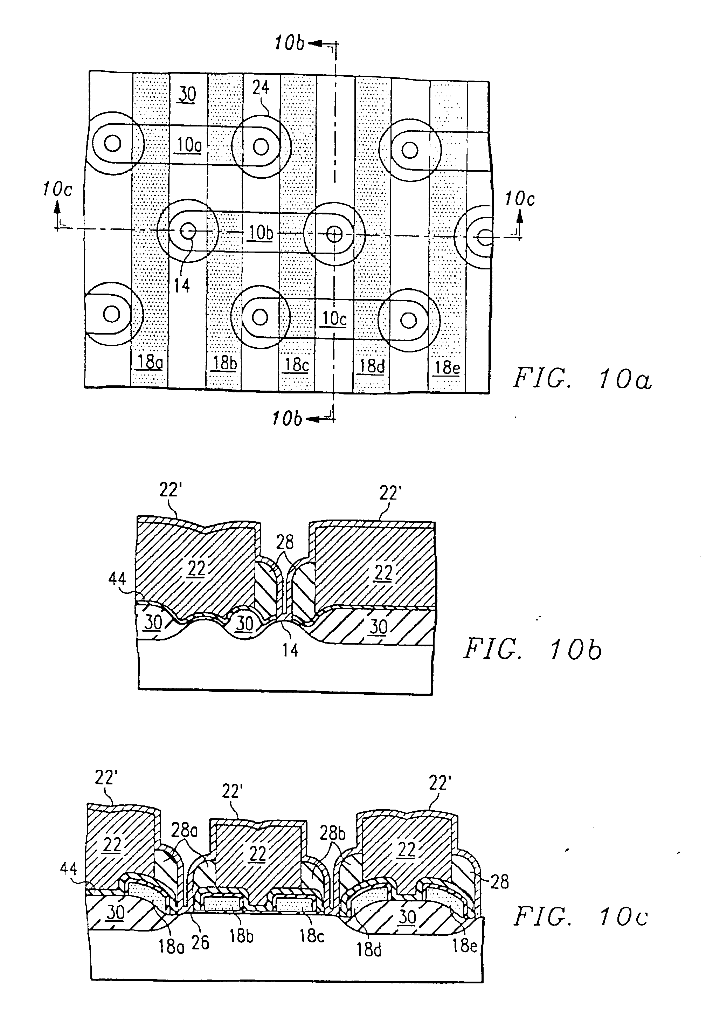

An illustrated in Figure 10, the storage node 22 is completed by depositing a layer 22 of conductive material, preferably doped polysilicon. Other conductive materials such as metal (e.g., aluminum, copper) can alternatively be used. In this embodiment, conductive material 22 functionally electrically couples the storage node 22 with the storage node contact region 14 and for all practical purposes becomes a part of the storage node 22. The conductive layer 22 may be the same material as the storage node 22 but does not have the be. For example, the originally deposited storage node 22 may comprise polysilicon while the conductive layer 22' comprises a metal.

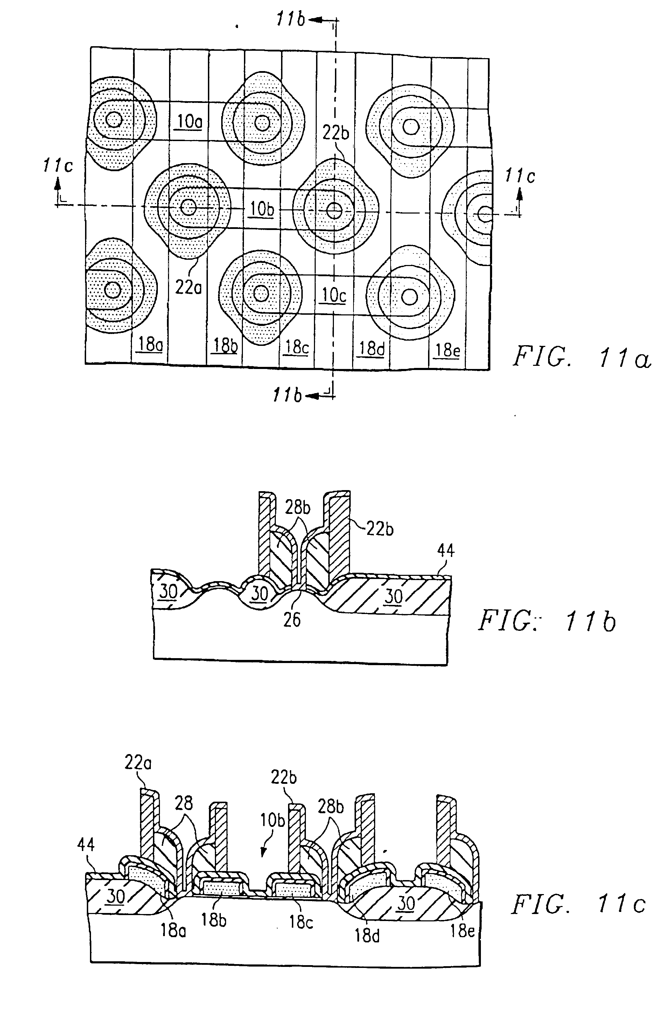

The storage node 22 is completed by patterning and etching the regions 22 and 22'. The ensuing structure is illustrated in Figure 11. In this and subsequent figures, the entire storage node, which now includes portions of layer 22 and layer 22', has been labeled with reference numeral 22. Referring to Figure 11c, the storage node of the memory cell on the left hand side of active region 10b has been labeled 22a and the storage node on the right hand side of active region 10b has been labeled 22b. In keeping with this convention, the spacer regions have been labeled 24a and 24b.

After formation of the storage node 22, a hemispherical grain (HSG) can be formed. Watanabe et al. teach a method of forming an HSG-Si on an amorphous silicon surface using a seeding method. This process could be used in conjunction with the present invention. See Watanabe et al., "A New Cylindrical Capacitor Using Hemispherical Grained Si (HSG-Si) for 256Mb DRAMs," 1992 IEDM, pp. 259-262,

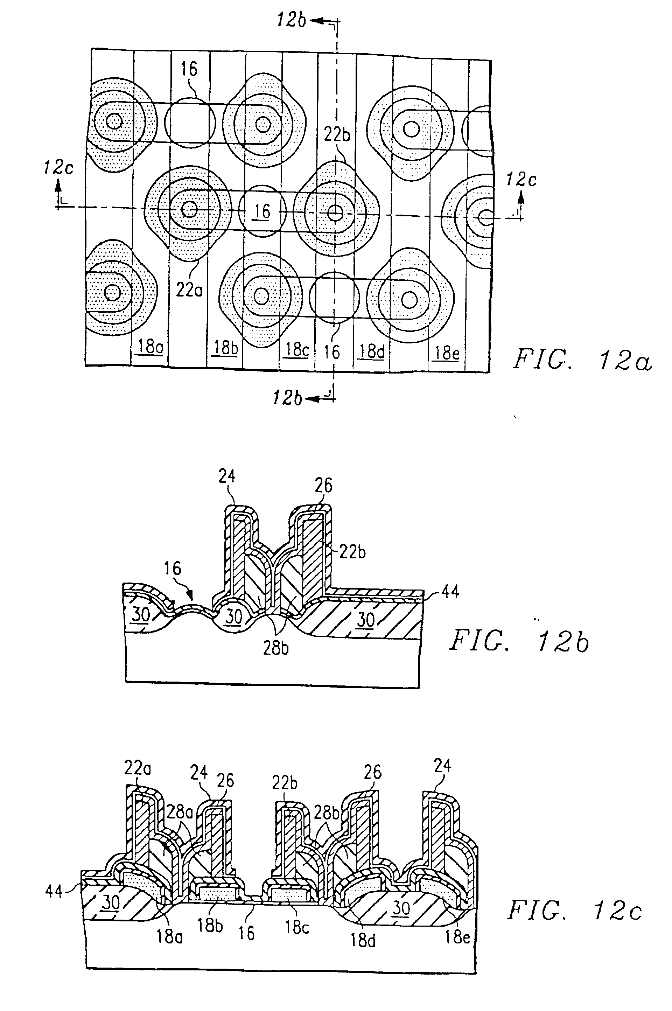

Referring next to Figure 12, capacitor dielectric 26 is formed over the device. In the preferred embodiment, the capacitor dielectric 26 comprises a NO (nitride-oxide) layer. Other dielectrics are also possible. High K dielectrics such as a perovskite, pyroelectric or ferroelectric material are especially attractive because use of these materials will help maximize the capacitance of the storage cell. High K dielectrics are described in U.S Patent No. 5,348,893, U.S Patent No. 5,471,364, U.S Patent No. 5,566,045 and in published European Patent document No. 0,697,720, European Patent document No. 0,697,717 and European Patent document No. 0,618,597. It is noted that the use of a high-K dielectric as described in one of these incorporated cases may require adjustment of the preferred materials described thus far. Also, the process flow will be adjusted as described in these other cases.

Conductive layer 24 is then formed over the capacitor dielectric 26. This conductive layer 24 will comprise the second plate of the storage cell's capacitor 20. In the preferred embodiment, this conductive layer 24 comprises heavily doped polysilicon but other conductors such as metals or metal silicides are also usable.

The conductive layer 24 is then patterned and etched to expose the portion of layer 44 over region 16. The region 16 will become the region where the bit line 34 contacts the pass transistor 12 (see Figure 1b). Figure 12a illustrates a number of circles labeled with reference numeral 16. These circles 16 represent the portions of the memory array where the capacitor plate 16 has been removed. As shown in the figure, each memory cell in the bank will share a single capacitor plate 24. In operation (e.g., when the memory cell is written to or read from), the capacitor plate 24 will be held a constant voltage (e.g., V_{cc}/2). The circuitry which generates this voltage is located in the cell periphery and accordingly is not illustrated here.

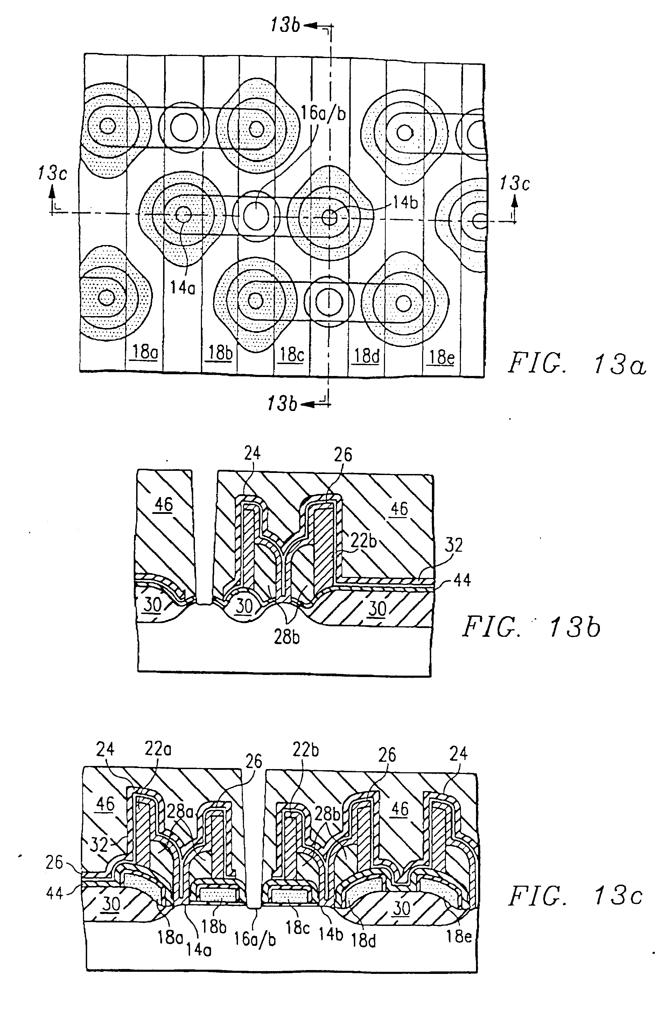

Figure 12 illustrates each of the elements in a single storage cell. Figures 13-17 illustrate additional steps which can be performed to complete the fabrication of the memory device.

In Figure 13, the region 16a/b is doped. An insulating layer 46 is then formed over the entire device and etched to expose the regions 16. The insulating region 46 may comprise a glass material such as BPSG (borophosphosilicate glass) or PSG (phosphosilicate glass).

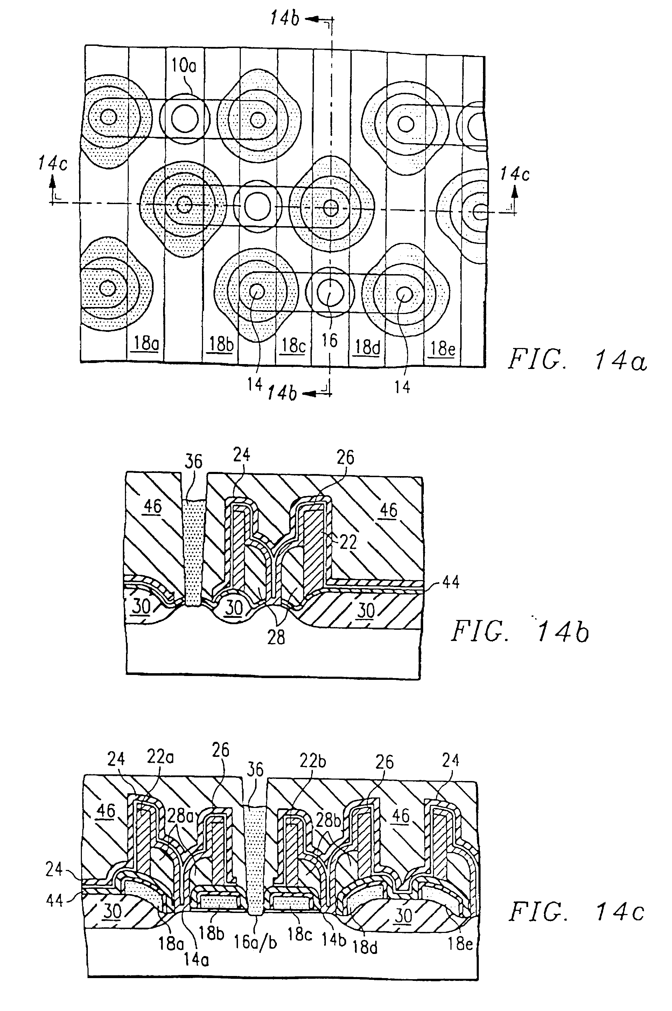

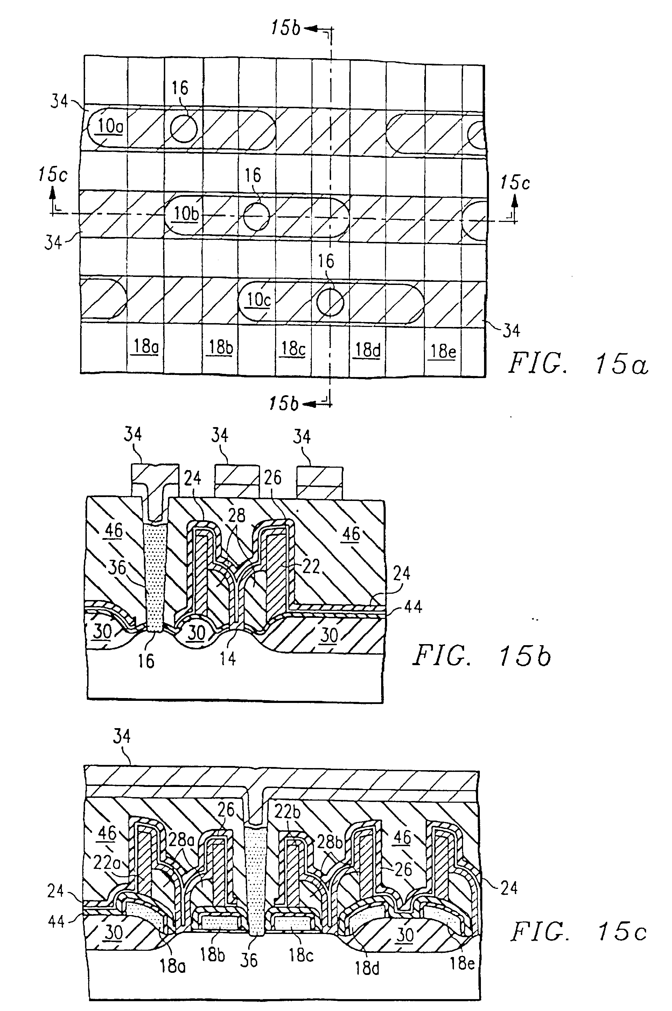

In Figure 14 the bit line contact 36 is formed so as to be electrically coupled the bit line contact region 16 to the bit line 34 (shown in Figure 15). In the preferred embodiment, the bit line contact 36 comprises doped polysilicon but other materials can also be used. In the preferred embodiment, the bit line 34 comprises a metal material such as titanium or tungsten. Other metals such as aluminum, copper, gold, silver, molybdenum or cobalt can also be used. Alternatively, a metal silicide or polysilicon layer can be used. Any of these materials can also be used in combination.

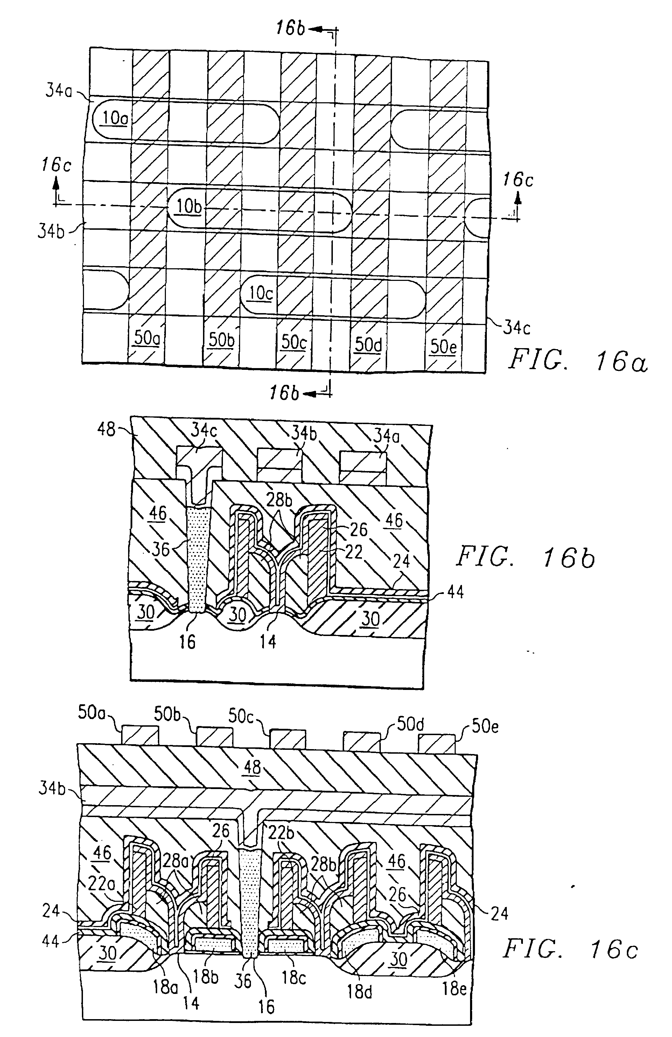

Figure 16 illustrates the formation of insulating layer 48 and conductive layer 50. Conductive layer 50 is used to form interconnects between various elements in the memory array and peripheral. The insulating layer 48 and conductive layer 50 may be formed from the same choices of materials described above with respect to insulating layer 46 and bit line 34. In any given device, the insulating layers 46 and 48 may or may not be made from the same material. Similarly, the conductive layers 34 and 50 may or may not be formed from the same material.

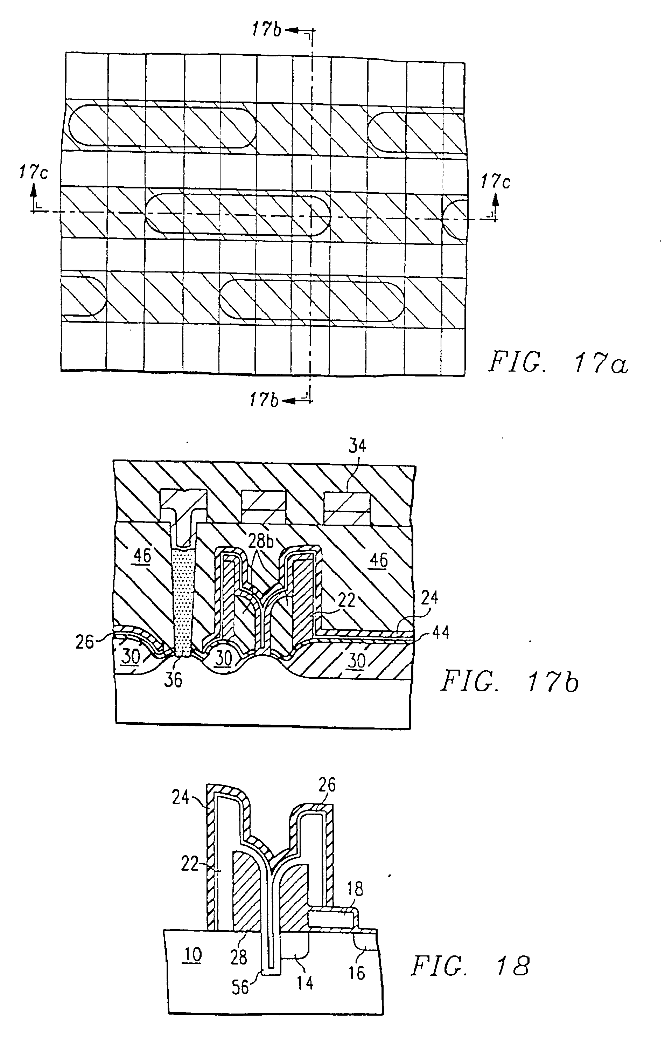

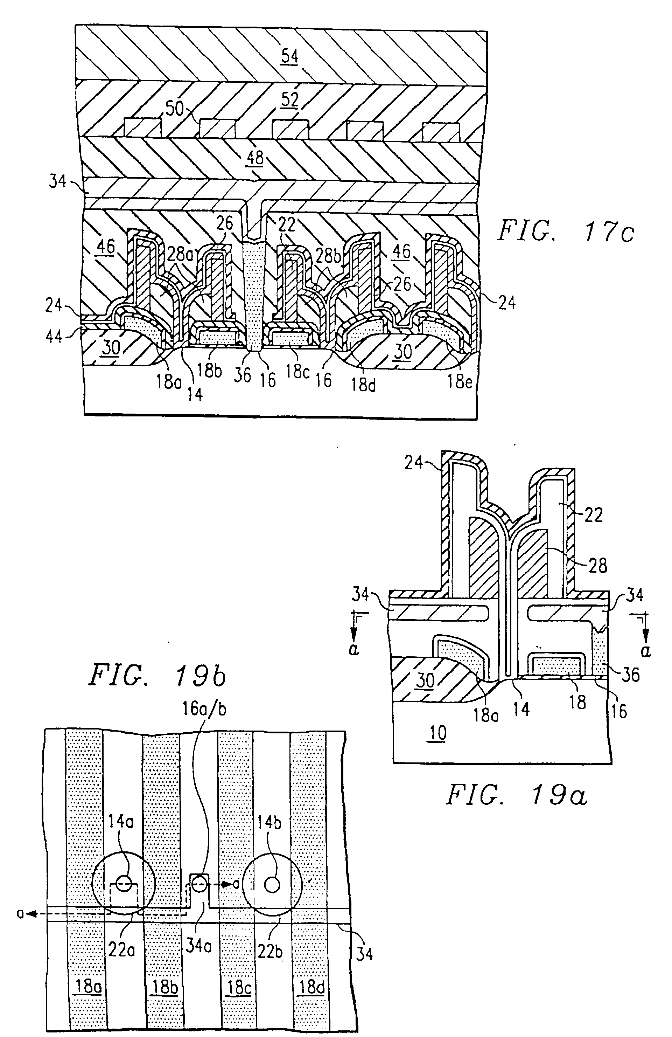

Figure 17 illustrates the final structure of the device. Insulating layer 52 has been formed over conductive layer 50 and a protective overcoat 54 has been formed over the entire device.

As discussed above, Table 1 provides a more detailed example of specific process steps which may be performed to create a DRAM embodying the present invention. Many of the steps provided in Table 1 have not been explicitly discussed in the preceding description. It is understood, however, that these steps are a part of the presently preferred embodiment.

Although, a detailed disclosure of one specific process has been provided, it should also be understood that many variations are also possible. The order of the steps may be changed. In alternate embodiments, some steps will be omitted while other steps are added. The fact that one specific process has been provided in great detail should not be taken to limit the scope of the invention.

**Table 1**

| **Step** | **Figure** | **Process Step** | **Process Parameter Range (Preferred)** |
|---|---|---|---|
| 1 | Figure 4 | Pad Oxidation | 170 - 230 Å (200Å) |
| 2 | | Nitride Deposition | 1200 - 1400 Å (1300Å) |
| 3 | | N Tank Pattern | |
| 4 | | Nitride Etch | |
| 5 | | N Tank Implant (P+ or As+) | 120KeV 1 x 10¹³ cm⁻² |
| 6 | | N Tank Ash | |
| 7 | | N Tank Oxidation | 1300 - 1700 Å (1500Å ) |
| 8 | | N Tank Wet Etch | |
| 9 | | P Tank Implant | BF₂+ 60KeV 1 x 10¹³ cm⁻² |
| 10 | | Tank Drive | 130 - 270 Å (200Å) |
| 11 | | Tank Oxide Deglaze | |
| 12 | | Pad Oxidation | 120 - 140Å (130Å) |
| 13 | | Nitride Deposition | 1350 - 1650Å (1500Å ) |
| 14 | | Moat Pattern | |
| 15 | | Nitride Etch | |
| 16 | | Field Oxidation | 3600 - 4400Å (4000Å) |
| 17 | | Moat Etch | |
| 18 | | Pad Oxidation | 210-250A (230A) |
| 19 | | Pattern Buffed P-channel Stop | |
| 20 | | Implant (B+) Buried P-Channel Stop | 180KeV 5.0 x 10¹² cm⁻² |
| 21 | | Pattern Buried N-channel Stop | |
| 22 | | Implant (P++ or As++) Buried N-channel Stop | 250KeV 5.0 x 10¹² cm⁻² |
| 23 | | Anneal Buried N- and P-Channel Stops | |
| 24 | | Dummy Oxidation | 110 - 130 Å (120Å) |
| 25 | | Pattern N-channel V_{T} Adjust | |
| 26 | | Implant (BF₂+) N-channel V_{T} Adjust | 120KeV 4.0 x 10¹¹ cm⁻² |
| 27 | | Pattern Low V_{T} N-channel Stop | |
| 28 | | Implant (P+ or As+) V_{T}N-channel Stop | 120KeV 1.1 x 10¹² cm⁻² |
| 29 | | Pattern P-channel V_{T} Adjust | |
| 30 | | Implant (BF₂+) P-channel V_{T} Adjust | 40KeV 7.0 X 10¹² cm⁻² |
| 31 | | Implant VPP (P+ or As+) | 80KeV 1.2 x 10¹² cm⁻² |
| 32 | | Transfer Gate V_{T} Adjust Pattern | |
| 33 | | Implant Transfer Gate V_{T} Adjust (BF2+) (Array) | 140KeV 2.4 x 10¹² cm⁻² |
| 34 | | Gate Oxidation | 110 - 130 Å (120Å) |
| 35 | Figure 5 | Polysilicon Deposition | 1350 - 1650Å (1500Å) |
| 36 | | Gate Pattern | |
| 37 | | Gate Polysilicon Etch | |
| 38 | Figure 6 | Polysilicon Fill Oxidation | 200 - 800 Å (400Å) |
| 39 | | Pattern N- for LDD | |
| 40 | | N- Implant for LDD (P+ or As+) | 40KeV 2.0 x 10¹³ cm⁻² |
| 41 | | Gate Cap Oxide Deposition | 450 - 550Å (500Å) |
| 42 | | Storage Node Polysilicon Deposition | 6555 - 7245Å(6900Å) |
| 43 | Figure 7 | Storage Node Contact Pattern | |
| 44 | | Storage Node Contact Polysilicon Etch | |
| 45 | Figure 8 | Storage Node Contact Sidewall Oxide Etch | 2070 - 2530 Å (2300Å) |
| 46 | Figure 9 | Storage Node Contact Sidewall Oxide Etch | 5500 - 6500 Å (-6000Å) |
| 47 | Figure 10 | Storage Node Contact Polysilicon Deposition | 630 - 770 Å (700Å) |
| 48 | Figure 11 | Storage Node Pattern | |
| 49 | | Storage Node Poly Etch | |
| 50 | Figure 12 | Gate Nitride Deposition | 50 - 60 Å(55Å) |
| 51 | | Nitride Oxidation | 270 - 370 Å (320Å) |
| 52 | | Plate Polysilicon Deposition | 630 - 770 Å(700Å) |
| 53 | | Acid Deglaze | |
| 54 | | Plate Pattern | |
| 55 | | Plate Polysilicon Etch | |
| 56 | Figure 13 | LDD Oxide Deposition | 630 - 770Å (700Å) |
| 57 | | LDD Pattern | |
| 58 | | LDD Oxide Etch | |
| 59 | | Cap Oxide Deposition | |
| 60 | | N+ Source/Drain Pattern | |
| 61 | | N+ Source/Drain Implant (As or P) (Periphery) | 40 KeV 2 x 10¹⁵ cm⁻² |
| 62 | | P+ Source/Drain Pattern | |
| 63 | | P+ Source/Drain Implant (BF2+) (Periphery) | 25 KeV 2 x 10¹⁵ cm⁻² |
| 64 | | MLO MTO Deposition | 450 - 550 Å (500Å) |
| 65 | | MLO BPSG Deposition | 9000 - 11000 Å (10000Å) |
| 66 | | Densify | |
| 67 | | Periphery Etch Back Pattern | |
| 68 | | Periphery Etch Back | |
| 69 | | MLO Reflow | |
| 70 | | MLO Etch Back | |
| 71 | | Bit Line Contact Pattern | |
| 72 | | Bit Line Contact Dry Etch | |
| 73 | Figure 14 | Bit Line Contact Polysilicon Deposition | 4500 - 5500 Å(5000Å) |
| 74 | | Bit Line Contact Polysilicon Anneal | |
| 75 | | PE Polysilicon Etch | |
| 76 | Figure 15 | C/T Pattern | |
| 77 | | C/T Dry Etch | |
| 78 | | C/T Ti-TiN Sputter | 400Å -1200Å; 3.9 - 4.1 ohm/square (4.0 ohm/square) |
| 79 | | C/T Ti-TiN Form | |
| 80 | | Metal 1 CVD-Tungsten Deposition | 1000 - 3500 Å(2000Å) |
| 81 | | Metal 1 Pattern | |
| 82 | | Metal 1 Etch | |
| 83 | Figure 16 | PTEOS 1 Deposition | 4500 - 5500 Å (5000Å) |
| 84 | | SOG Coat & Cure | 3000 - 3300 Å (3150Å) |
| 85 | | Spin-on-Glass Etch Back | 3800 - 4200 Å (-4000Å) |
| 86 | | PTEOS Deposition | 4500 - 5500 Å (5000Å) |
| 87 | | Via Contact Pattern | |
| 88 | | Via Dry Etch | |
| 89 | | Clean Post Via | |
| 90 | | Triple Level Metal W Sputter | 200 - 1500 Å (500Å) |
| 91 | | Triple Level Metal CVD-W Deposition | 500 - 3000 Å (1500Å) |
| 92 | | Triple Level Metal Pattern | |
| 93 | | Triple Level Metal Etch | |
| 94 | Figure 17 | PTEOS Deposition | 4500 - 5500 Å (5000Å) |
| 95 | | SOG Coat & Cure | 3000 - 3300 Å (3150Å) |
| 96 | | SOG Etch Back | 3800 - 4200 Å (-4000Å) |
| 97 | | PTEOS Deposition | 3150 - 3850 Å (3500Å) |
| 98 | | Via Pattern | |
| 99 | | Via Dry Etch | |
| 100 | | Clean Post Via | |
| 101 | | Metal Tungsten Sputter | 200 - 1500 Å (500Å ) |
| 102 | | Metal CVD-Tungsten Deposition | 500 - 2500 Å (1000Å ) |
| 103 | | Metal Al-Si-Cu Sputter | 1000 - 10,000 Å (4000Å ) |
| 104 | | Metal ARC TiN | 200 - 1500 Å (500Å ) |
| 105 | | Metal Pattern | |
| 106 | | Metal Etch | |
| 107 | | Protective Overcoat (P/O) Oxide 1 Deposition | 3150 - 3850 Å (3500Å) |
| 108 | | P/O Oxide 2 Deposition | 3600 - 4400 Å (4000Å) |
| 109 | | P/O Oxide Etch Back | 3000 - 4000 Å (-3500Å) |
| 110 | | P/O Oxide 3 Deposition | 1800 - 2200 Å (2000Å) |
| 111 | | Metal Sinter | |
| 112 | | Fuse Pattern | |
| 113 | | Fuse Etch | |
| 114 | | Parametric Test | |
| 115 | | Laser Repair | |
| 116 | | Protective Overcoat | 8100 - 9900 Å(9000Å) |
| | | Deposition | |
| 117 | | Protective Overcoat Pattern | |
| 118 | | Protective Overcoat Cure | |
| 119 | | Protective Overcoat Etch | |
| 120 | | Back Grind | |
| 121 | | Multi Probe Test | |
| 122 | | Quality Control Acceptance | |
| 123 | | Package | |
| 124 | | Ship | |

An alternate embodiment memory cell is illustrated in Figure 18. Figure 18 is similar to Figure la except that capacitor plates 22 and 24 extend into a trench 56 formed in active area 10. By using trench 56 as illustrated in Figure 18, the surface area between the capacitor plates 22 and 24 can be further increased. The stacked capacitor in a trench cell of Figure 18 can be used with trench isolation (where trench 56 is possibly formed at the same time as the isolation trenches) or with field isolation.

In an alternative embodiment that is not illustrated, the storage node 22 end at the surface of the semiconductor layer 10 that the plate extends into a trench 56. In this embodiment, the plate 22 can be completed by doping the surface of the trench.

Another embodiment of the present invention is illustrated in Figure 19a and 19b which illustrates a capacitor-over-bitline (COB) type memory cell. In this embodiment, the capacitor 12 has a portion which is over the bit line 34. A plan view of one such embodiment is illustrated in Figure 19b. In this case, the bit line 34 extends in parallel to the line of memory cells and include extending portion 34a to contact to the bit line contact 36. Other variations of this structure are also possible.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A memory cell including a transistor and a capacitor, the memory cell comprising:
a transfer gate formed over a semiconductor region and insulated therefrom;
a channel region disposed in the semiconductor region beneath the transfer gate;
a bit line contact region disposed in the semiconductor region adjacent a first edge of the transfer gate;
a storage node contact region disposed in the semiconductor region adjacent a second edge of the transfer gate, the storage node contact region spaced from the bit line contact region by the channel region;
a cylindrical spacer region disposed around the storage node contact region;
a conductive storage node surrounding inner, outer and upper portions of the spacer region and electrically coupled to the storage node contact region; and
a conductive plate capacitively coupled to the conductive storage node.

2. The memory cell of Claim 1 further comprising; a bit line coupled to the bit line contact region wherein the bit line extends over the storage node and conductive plate.

3. The memory cell of Claim 1 or Claim 2, wherein the storage node overlies a portion of the transfer gate adjacent the first edge of the transfer gate.

4. The memory cell of any preceding claim further comprising; a word line formed over the semiconductor region and spaced from the transfer gate by the storage node contact region, the word line including a first edge adjacent the storage node contact region.

5. The memory cell of Claim 4, wherein the storage node overlies a portion of the transfer gate adjacent the first edge of the transfer gate and overlies a portion of the word line adjacent the first edge of the word line.

6. The memory cell of any preceding claim, wherein the transfer gate is formed from a material comprising silicon.

7. The memory cell of any preceding claim, wherein the plate is separated from the storage node by a high dielectric constant material.

8. The memory cell of any of Claims 1 to 6, wherein the plate is separated from the storage node by a layer which comprises a nitride and an oxide.

9. The memory cell of any of Claims 1 to 6, wherein the plate is separated from the storage node by a nitride layer.

10. The memory cell of any of Claims 1 to 6, wherein the plate is separated from the storage node by a tantalum pentoxide layer.

11. The memory cell of any preceding claim, wherein the storage node abuts the surface of the semiconductor region at the storage node contact region.

12. A memory cell comprising;
a pass transistor disposed at the surface of a semiconductor layer, the pass transistor comprising first and second semiconductor regions separated by a channel region and a transfer gate overlying the channel region;
a spacer region extending upward from the semiconductor layer and including an opening over the second semiconductor region; and
a capacitor electrically coupled to the second semiconductor region, the capacitor including two capacitively coupled and conductive layers one of which abuts the second semiconductor region, wherein the capacitively coupled layers extend away from a portion of the semiconductor layer adjacent an inner portion of the spacer, over the spacer and back toward a portion of the semiconductor layer adjacent an outer portion of the spacer.

13. The memory cell of Claim 12, wherein the spacer region comprises a cylindrical spacer and the capacitively coupled layers substantially surround the cylindrical spacer.

14. The memory cell of Claim 13, wherein the cylindrical spacer has a substantially circular cross-section.

15. The memory cell of any of Claims 12 to 14 further comprising; a bit line coupled to the bit line contact region wherein the bit line extends over the storage node and conductive plate.

16. The memory cell of any of Claims 12 to 15, wherein the two capacitively coupled conductive layers are separated by a high dielectric constant material.

17. The memory cell of any of Claims 12 to 15, wherein the two capacitively coupled conductive layers are separated by a layer which comprises a nitride and an oxide.

18. The memory cell of any of Claims 12 to 15, wherein the two capacitively coupled conductive layers are separated by a nitride layer.

19. The memory cell of any of Claims 12 to 15, wherein the two capacitively coupled conductive layers are separated by a tantalum pentoxide layer.

20. A method of forming a capacitor for a semiconductor device, said method comprising the steps of:
forming a first conductive layer over a surface;
patterning and etching the conductive layer to form an opening within the conductive layer, the opening exposing a portion of the surface;
forming a sidewall spacer along inner walls of the opening;
forming a second conductive layer over the first conductive layer, the sidewall insulator and the exposed portion of the surface;
patterning and etching the first and second conductive layers to form a storage node conductor, the storage node conductor surrounding the sidewall insulator;
forming a dielectric layer over the storage node conductor; and
forming a third conductive layer over the dielectric layer.

21. The method of Claim 20, wherein the step of forming a sidewall spacer comprises the steps of:
conformally depositing a layer of insulating material; and
anisotropically etching the layer of insulating material to form the sidewall spacer along the inner walls of the opening.

22. The method of Claim 20 or Claim 21, wherein the steps of forming the first conductive layer and the second conductive layer both comprise forming silicon layers.

23. The method of any of Claims 20 to 22, wherein the patterning and etching steps comprise forming an opening exposing a portion of the surface which is no greater than about 0.45 microns at its greatest diameter.

24. The method Claim 23, wherein the step of forming the sidewall spacer comprises forming a sidewall spacer no greater than about 0.15 microns thick.

25. The method of any of Claims 20 to 24 wherein the patterning and etching steps comprise forming an exposed portion of the surface comprising a semiconductor material.

26. The method Claim 25 further comprising; the step doping the exposed potion of the semiconductor material.

27. The method of any of Claims 20 to 26, further comprising ; providing a storage capacitor of a dynamic random access memory cell.

28. A synchronous memory device comprising;
a plurality of address terminals for receiving row and column addresses;
at least one of data terminal for receiving input signals from circuitry external of said array and for providing output signals to circuitry external of said array; and at plurality of memory cells, each of the memory cells comprising:
a pass transistor disposed at the surface of a semiconductor layer, the pass transistor comprising first and second semiconductor regions separated by a channel region and a transfer gate overlying the channel region;
a spacer region extending upward from the semiconductor layer and including an opening over the second semiconductor region; and
a capacitor electrically coupled to the second semiconductor region, the capacitor including two capacitively coupled conductive layers one of which abuts the second semiconductor region wherein the capacitively coupled layers extend away from a portion of the semiconductor layer adjacent an inner portion of the spacer, over the spacer and back towards a portion of the semiconductor layer adjacent an outer portion of the spacer, and
wherein at least one of said memory cells is selected based on the row and column address and information stored in said at least one of said memory cells is coupled to said at least one data terminal.
